# EUROPÄISCHE PATENTSCHRIFT

(11) **EP 1 037 717 B1**
(45) Veröffentlichungstag und Bekanntmachung des Hinweises auf die Patenterteilung: **19.03.2003**
(21) Anmeldenummer: 98966253.1
(22) Anmeldetag: 03.12.1998
(51) Int. Cl.: B05D 1/00

(54) **MODIFIKATION VON OBERFLÄCHEN ZUR STEIGERUNG DER OBERFLÄCHENSPANNUNG**
MODIFICATION OF SURFACES IN ORDER TO INCREASE SURFACE TENSION
MODIFICATION DE SURFACES EN VUE D'ACCROITRE LA TENSION DE SURFACE

(30) Priorität: 04.12.1997 DE 19753848
(43) Veröffentlichungstag der Anmeldung: 27.09.2000
(73) Patentinhaber: Roche Diagnostics GmbH, 68298 Mannheim (DE)
(72) Erfinder: ZIMMER, Volker, D-69221 Dossenheim (DE); BRAUN, Hans-Peter, D-69469 Weinheim (DE)
(86) Internationale Anmeldenummer: EP9807851
(87) Internationale Veröffentlichungsnummer: WO99029435

(56) Entgegenhaltungen:
- EP-A- 0 045 416
- FR-A- 1 373 816
- FR-A- 2 100 817
- GB-A- 895 879
- GB-A- 1 084 696
- GB-A- 2 075 556
- US-A- 3 926 564
- US-A- 4 759 805

## Beschreibung

Die Erfindung betrifft ein Verfahren zur Herstellung von Oberflächenbeschichtungen sowie die Verwendung einer Oberflächenbeschichtung zur Erhöhung der Oberflächenspannung von Gegenständen.

Das Beschichten von Oberflächen von festen Gegenständen ist ein weit verbreitetes Mittel, um die Oberflächeneigenschaften der Gegenstände gezielt zu verändern. Es sei hier nur hingewiesen auf die unzähligen Methoden des Korrosionsschutzes für Alltagsgegenstände aus unedlen Metallen oder die Lackierung von Gegenständen mit dem Ziel, deren optisches Erscheinungsbild zu verändern.

Unter Beschichten wird allgemein ein Fertigungsverfahren zum Aufbringen einer fest haftenden Schicht aus formlosem Stoff auf ein Werkstück oder eine Trägerbahn verstanden. Man kann prinzipiell 4 Gruppen von Beschichtungsverfahren unterscheiden, die sich jeweils durch den Zustand des Beschichtungsstoffes vor dem Beschichten unterscheiden:
1. Beschichten aus dem gasförmigen oder dampfförmigen Zustand, wie zum Beispiel Aufdampfen oder Metallisierung;
2. Beschichten aus dem flüssigen, breiigen oder pastenförmigen Zustand, wie beispielsweise Lackieren, Dispersions- oder Schmelzbeschichten;
3. Beschichten aus dem ionisierten Zustand durch elektrolytisches oder chemisches Abscheiden, wie unter anderem das Eloxal-Verfahren oder die elektrophoretische Lackierung;
4. Beschichten aus dem festen, das heißt körnigen oder pulvrigen Zustand, beispielsweise die Pulverbeschichtung oder die Beschichtung durch Sintern.

Für Anwendungsbereiche, in denen preisgünstige Einmalartikel benutzt werden, insbesondere auch in der medizinischen Diagnostik oder der Umweltanalytik, haben sich Kunststoffe als Fertigungsmaterial der Wahl herausgestellt. Da Kunststoffe - insbesondere preiswerte, leicht zu verarbeitende, nahezu beliebig formbare Massenkunststoffe - in der Regel aus unpolaren organischen Polymeren bestehen, sind diese meist von polaren Medien, wie Wasser und wäßrigen Flüssigkeiten, insbesondere biologischen Proben, nicht oder nur schlecht benetzbar. Diese Eigenschaft macht man sich für gewisse Anwendungen zu Nutze, beispielsweise dort, wo ein Anhaften der Flüssigkeit an den Kunststoffgegenstand nicht gewünscht wird, wie bei Einwegpipettenspitzen. Andererseits gibt es zahlreiche Anwendungsgebiete für Kunststoffgegenstände, bei denen eine Benetzbarkeit mit polaren Flüssigkeiten gewünscht ist, wie zum Beispiel im Bereich der Schnelldiagnostika, bei denen Kunststoffe als Materialien zur Aufnahme von biologischen Probenflüssigkeiten dienen können.

Deshalb mangelt es nicht an unterschiedlichen Verfahren, die eine hydrophile Modifikation von Kunststoffoberflächen zum Ziel haben. Hydrophile Oberflächen zeichnen sich durch eine hohe Oberflächenspannung aus, die einen Wert nahe dem Wert der Oberflächenspannung von Wasser (72 mN/m) besitzen. Beispielhaft erwähnt für eine hydrophile Modifikation von Kunststoffoberflächen seien die Corona-Plasma-Behandlung, die Plasma Chemical Vapor Deposition (PACVD, bspw. Fa. Antec, Kelkheim), die beispielsweise in US 4,973,493 beschriebene kovalente Bindung von photoreaktiv ausgerüsteten, hydrophilen Polymeren auf eine Kunststoffoberfläche (Photo Link Surface, Fa. BSI Corporation, Eden Prairie, Minnesota, USA), das Aufbringen netzmittelhaltiger Schichten auf die Kunststoffoberfläche (bspw. Fa. Adhesive Research, Glen Rock, PA, USA), oder das Beschichten von anorganisch-organischen Nanokompositen mittels Sol-Gel-Technologie auf die zu modifizierenden Oberflächen (bspw. Fa. INM, Saarbrücken).

Für die hydrophile Modifikation von Kunststoffoberflächen, sei es von Folien oder von Formteilen, haben sich unter anderem die oben genannten Verfahren etablieren können, die jeweils Vor- und Nachteile aufweisen.

Die Corona-Plasma-Behandlung führt zu einer Erhöhung der Oberflächenspannung, die nach der Behandlung kontinuierlich über einen kurzen Zeitraum von mehreren Tagen bis zu wenigen Wochen abnimmt. Zudem sind die erreichbaren Oberflächenspannungen vergleichsweise gering.

Geringfügig höhere Oberflächenspannungen als mit der Corona-Plasma-Behandlung sind mit der PACVD-Technik zu erreichen. Obwohl diese Methode zu zeitlich stabileren Oberflächenbeschichtungen führt ist auch hier eine Abnahme der Oberflächenspannung mit der Zeit zu beobachten.

Zeitlich stabil hinsichtlich ihrer Oberflächenspannung sind Oberflächen, die mit. sogenannten Photo Link Surfaces ausgestattet sind oder auf die eine Beschichtung mit netzmittelhaltigen Schichten erfolgt ist. Beide Varianten führen jedoch nicht zu optimal hohen Oberflächenspannungen. Die Beschichtung mit Netzmittelhaltigen Schichten birgt zusätzlich den prinzipiellen Nachteil in sich, daß sich das Netzmittel in einer flüssigen, wäßrigen Probe, die in Kontakt mit der Schicht gebracht wird, anreichern und diese somit verändern oder unbrauchbar machen kann.

Das Beschichten von anorganisch-organischen Nanokompositen mittels Sol-Gel-Technologie auf die zu modifizierenden Oberflächen führt zu erhöhten Oberflächenspannungen. Nachteilig dabei ist, daß das Verfahren selbst aufwendig und zeitintensiv ist, weshalb es für die Modifikation von Kunststoffmassenartikeln nicht geeignet erscheint.

Die Aufgabe der vorliegenden Erfindung war es, die Nachteile des Standes der Technik zu beseitigen. Insbesondere sollten zeitlich stabile Oberflächenbeschichtungen mit hoher Oberflächenspannung, beispielsweise zur Verwendung für die hydrophile Modifikation von Gegenständen, bereitgestellt werden. Zudem sollte die Beschichtung einfach und zuverlässig durchzufiihren sein, um somit für die Modifikation von Massenartikeln geeignet zu sein.

Die Aufgabe wird durch den Gegenstand der Erfindung, wie er in den Patentansprüchen charakterisiert ist, gelöst.

Gegenstand der Erfindung ist die Verwendung einer Oberflächenbeschichtung zur Steigerung der Oberflächenspannung von Gegenständen, dadurch gekennzeichnet, daß die Oberflächenbeschichtung durch Abscheiden einer Schicht zumindest eines mit Wasser oxidierbaren Elements oder einer mit Wasser oxidierbaren Legierung und anschließendes Einwirken von siedendem Wasser oder Wasserdampf auf die abgeschiedene Schicht erhalten wird.

Vorzugsweise wird zur Behandlung der abgeschiedenen Oberflächenbeschichtung siedendes Wasser oder Wasserdampf, besonders bevorzugt entionisiertes Wasser, eingesetzt.

Die Erhöhung der Oberflächenspannung resultiert aus einer Steigerung der Polarität und entspricht einer gesteigerten Hydrophilie der betrachteten Oberflächen. Die Hydrophilie ist die Wasseraffinität einer Oberfläche. Hydrophile Oberflächen sind in diesem Zusammenhang wasseranziehende Flächen. Wäßrige Proben, darunter auch biologische Proben wie Blut, Urin, Speichel, Schweiß, und daraus abgeleitete Proben wie Plasma und Serum, spreiten auf solchen Oberflächen gut. Solche Flächen sind unter anderem dadurch charakterisiert, daß an der Grenzfläche ein Wassertropfen auf ihnen einen spitzen Rand- oder Kontaktwinkel ausbildet. (Vgl. dazu bspw. die Ausführungen unter dem Stichwort "Benetzung" in CD Römpp Chemie Lexikon Version 1.0, 1995) Im Gegensatz dazu wird auf hydrophoben, das heißt wasserabweisenden Oberflächen, an der Grenzfläche zwischen Wassertropfen und Oberfläche ein stumpfer Randwinkel ausgebildet.

Der Randwinkel als Resultat der Oberflächenspannungen der Prüfflüsigkeit und der zu untersuchenden Oberfläche ist als Maß für die Hydrophilie einer Oberfläche geeignet. Wasser hat beispielsweise eine Oberflächenspannung von 72 mN/m. Liegt der Wert der Oberflächenspannung der betrachteten Fläche weit, d. h. mehr als 20 mN/m, unter diesem Wert, so ist die Benetzung schlecht und der resultierende Randwinkel ist stumpf. Eine solche Fläche wird als hydrophob bezeichnet. Nähert sich die Oberflächenspannung dem Wert, der für Wasser gefunden wird, so ist die Benetzung gut und der Randwinkel wird spitz. Wird die Oberflächenspannung dagegen gleich oder größer dem für Wasser gefundenen Wert, so zerläuft der Tropfen und es findet Totalspreitung der Flüssigkeit statt. Ein Randwinkel ist dann nicht mehr zu messen. Flächen, die mit Wassertropfen einen spitzen Randwinkel bilden oder bei denen Totalspreitung eines Wassertropfens beobachtet wird, werden als hydrophil bezeichnet.

Erfindungsgemäß soll die Oberflächenbeschichtung durch Abscheiden einer Schicht zumindest eines mit Wasser oxidierbaren Elements oder einer mit Wasser oxidierbaren Legierung auf einen Gegenstand erfolgen. Als zu beschichtende Gegenstände kommen alle solchen Gegenstände in Frage, deren Oberfläche im unbeschichteten Zustand eine geringere Hydrophilie aufweisen als im beschichteten, nachbehandelten Zustand. Beispielsweise seien genannt Kunststoff, Metall, Glas, Keramik, Papier, Vlies, Karton, etc., wobei die Gestalt der Gegenstände beliebig sein kann, z. B. flächig, dreidimensional, porös etc.

Für das Abscheiden der Schicht kommen prinzipiell alle 4 oben genannten Beschichtungsverfahren in Betracht, d. h. Beschichten aus dem gasförmigen oder dampfförmigen Zustand, aus dem flüssigen, breiigen oder pastenfömigen Zustand, aus dem ionisierten Zustand oder aus dem festen Zustand. Vorzugsweise findet das Beschichten aus dem gasförmigen Zustand statt. Besonders bevorzugt wird auf die zu modifizierende Oberfläche in einem Vakuumbedampfer eine Schicht eines mit Wasser oxidierbaren Elements oder einer Legierung aufgebracht. Dieses Verfahren wird, beispielsweise mit Aluminium als mit Wasser oxidierbarem Element, kostengünstig in großen Flächen für die Verpackungsmittelindustrie und Elektroindustrie angewendet.

Die Schichten können auf den zu beschichtenden Gegenstand als zusammenhängende, ganzflächige Schicht, aber auch in Form beliebiger, zweidimensionaler Muster aufgebracht werden.

Wesentlich für den Erfindungsgegenstand ist, daß die abgeschiedene Schicht des mit Wasser oxidierbaren Elements oder der mit Wasser oxidierbaren Legierung im Anschluß an den eigentlichen Beschichtungsvorgang durch Einwirken von siedendem Wasser oder Wasserdampf behandelt wird. Dabei ist es ausreichend, siedendes Wasser oder Wasserdampf bei Normaldruck einwirken zu lassen. Vorzugsweise wird jedoch mit überhitztem Wasserdampf gearbeitet, da sich dabei die Einwirkzeiten deutlich reduzieren lassen. Beispielsweise kann eine 30 nm dicke Aluminiumschicht innerhalb von ca. 45 s mit überhitztem Wasserdampf vollständig durchoxidiert werden.

Bei dieser Behandlung wird die abgeschiedene Schicht des mit Wasser oxidierbaren Elements oder der mit Wasser oxidierbaren Legierung zumindest oberflächlich oxidiert. Zumindest die Oberfläche der abgeschiedenen Schicht des mit Wasser oxidierbaren Elements oder der mit Wasser oxidierbaren Legierung verliert dabei ihren elementaren Charakter. Für Metalle oder deren Legierungen bedeutet dies unter anderem den Verlust von Glanz und Leitfähigkeit. Die Oxidation der Oberfläche geht dabei über die gegebenenfalls als natürliche Schutzschicht vorhandene Schicht hinaus. Dünne metallische Schichten werden bei der Behandlung mit siedendem Wasser oder Wasserdampf so weit oxidiert, daß sie ihr metallisches Erscheinungsbild völlig verlieren und unter Umständen völlig transparent werden.

Die Behandlung mit siedendem Wasser oder Wasserdampf wird vorzugsweise mit reinem Wasser, besonders bevorzugt entionisiertem Wasser (bspw. Aqua purificata gemäß DAB) durchgeführt. Die hierbei erhaltenen Oberflächen weisen keine Belastung durch Chemikalien auf, die bei anderen, insbesondere naßchemischen Oxidationsverfahren, wie beispielsweise der Oxidation mit oxidierenden Säuren, zu finden sind. Reinigungs- und Spülschritte entfallen daher und machen den Prozess einfacher und kostengünstiger.

Erfindungsgemäß einsetzbar zum Beschichten sind unedle, durch siedendes Wasser oder Wasserdampf oxidierbare Elemente. Vorzugsweise werden die Elemente Al, Si, Ti, V, Cr, Mn, Fe, Co, Ni, Zn, Ga, Ge, Zr, Nb, Cd, In, Sn, Sb. Besonders bevorzugt sind Al, Si, Ti, Zr. Ganz besonders bevorzugt ist Al.

Ebenfalls erfindungsgemäß einsetzbar sind unedle, durch siedendes Wasser oder Wasserdampf oxidierbare Legierungen. Vorzugsweise sind dies Legierungen, die zumindest zwei Komponenten der folgenden Gruppe von Elementen, bestehend aus Al, Si, Ti, V, Cr, Mn, Fe, Co, Ni, Zn, Ga, Ge, Zr, Nb, Cd, In, Sn und Sb, enthält. Beispielsweise ist geeignet eine Legierung aus 99 Gew.-% Al und 1 Gew.-% Si.

Ebenfalls geeignet sind Legierungen, die zumindest eine Komponente der folgenden ersten Gruppe von Elementen, bestehend aus Al, Si, Ti, V, Cr, Mn, Fe, Co, Ni, Zn, Ga, Ge, Zr, Nb, Cd, In, Sn und Sb, enthalten, die mit zumindest einem Element der folgenden zweiten Gruppe von Elementen, bestehend aus Mg, Ca, Sr und Ba, legiert sind, wie zum Beispiel eine Legierung aus 95 Gew.-% Al und 5 Gew.-% Mg. Besonders bevorzugt sind Legierungen, die zumindest eine Komponente der folgenden ersten Gruppe von Elementen enthalten, bestehend aus Al, Si, Ti und Zr, die mit zumindest einem Element der folgenden zweiten Gruppe von Elementen, bestehend aus Mg, Ca, Sr und Ba, legiert sind. Ganz besonders bevorzugt sind Legierungen die aus Al bestehen, welches mit zumindest einem Element der folgenden Gruppe von Elementen, bestehend aus Mg, Ca, Sr und Ba, legiert sind.

Die erfindungsgemäß abgeschiedene Schicht weist vorzugsweise eine Dicke von 1 nm bis 500 nm auf. Die Einwirkung von siedendem Wasser oder Wasserdampf auf die abgeschiedene Schicht führt zur Bildung von Oxidschichten, die bevorzugt zwischen 0,1 nm und 500 nm, besonders bevorzugt zwischen 10 nm und 100 nm dick sind.

Die erfindungsgemäß erzeugten Oberflächenbeschichtungen stellen homogene, anorganische Oxidschichten dar, die hohe Oberflächenspannung und hohe Polarität besitzen, die über lange Zeit stabil sind und eine gute Haftfähigkeit bei gleichzeitiger Elastizität auf dem beschichteten Gegenstand aufweisen.

Die Charakterisierung von Oberflächen mit hohen Oberflächenspannungen ("hochenergetische Oberflächen") bereitet gewisse meßtechnische Probleme. Bei verschiedenen Meßverfahren, wie z. B. der Kontaktwinkelmessung, werden Grenzflächeneffekte der zu untersuchenden Oberfläche relativ zu Prüfflüssigkeiten herangezogen. Da Prüfflüssigkeiten mit Oberflächenspannungen, die deutlich über dem Wert für Wasser (72 mN/m) liegen, kaum herzustellen sind, sind der Extrapolierbarkeit über diesen Wert hinaus gewisse Grenzen gesetzt. Erschwerend kommen kinetische Effekte hinzu. Eine Flüssigkeit, die eine Oberfläche benetzt, spreitet über einen kurzen Zeitraum, typischerweise unter 1,5 s. Wichtig für die Bestimmung der Oberflächenspannung hinsichtlich Kapillaraktivität ist jedoch die spontane Benetzung. Beim dynamischen Kontaktwinkel-Verfahren spricht man vom Fortschreitwinkel der Benetzung eines ständig größer werdenden Tropfens. Allerdings ist für die hier vorgestellten hydrophilen Oberflächenbeschichtungen die Dosierung des Tropfens und die Vermessung des Tropfens mit den kommerziell erhältlichen Kontaktwinkel-Meßautomaten zu langsam, um die erfindungsgemäßen Oberflächenbeschichtungen eindeutig zu beschreiben. Es hat sich daher als praktikabel herausgestellt, die erfindungsgemäße Oberflächenbeschichtung mittels vergleichender Ermittlung der Füllzeit für eine Testkapillare zu vermessen.

Die zylindrische Testkapillare ist aus zwei sich parallel gegenüberliegenden Folien aufgebaut, die durch einen genau definierten Abstandhalter in Form eines beidseitig klebenden Klebebandes, der die Dimensionen Länge Breite und Höhe der Kapillare bestimmt, in einem definierten Abstand zueinander gehalten werden. Die sich gegenüberliegenden Oberflächen der beiden Folien sind mit der zu testenden Beschichtung versehen. Die Dimensionen der Kapillare sind 0,1 mm Höhe, 2 mm Breite und 15 mm Länge, wobei die Länge der Kapillare der verfügbaren Transportstrecke der Flüssigkeit entspricht und die Höhe der Kapillare diejenige Dimension ist, die die Kapillarität bewirkt. Die Kapillare besitzt eine der Aufnahme der Prüfflüssigkeit dienende Öffnung mit einer Querschnittsfläche von 0,1 mm x 2 mm, die der Grundfläche der zylindrischen Kapillare entspricht. Am gegenüberliegenden Ende der Kapillare ist eine Entlüftungsöffnung angebracht, die dem Entweichen der verdrängten Luft in der Kapillare beim Einsaugen der Prüfflüssigkeit dient. Die Prüfflüssigkeit ist vorzugsweise destilliertes Wasser, bspw. Aqua purificata gemäß DAB, jedoch sind je nach Anwendungsbereich der Oberflächenbeschichtung andere Prüfflüssigkeiten möglich, beispielsweise Blut oder andere Körperflüssigkeiten. Die Füllzeiten für die Prüfflüssigkeiten werden bei halber (7,5 mm Transportstrecke) und vollständiger Füllung (15 mm Transportstrecke) gemessen. Vergleichsergebnisse sind in Beispiel 1 beschrieben.

Besonders bevorzugt ist die erfindungsgemäße Verwendung von Oberflächenbeschichtungen in analytischen Testelementen zur Erhöhung der Hydrophilie. Gegenstand der Erfindung ist daher auch ein analytisches Testelement, bspw. ein Teststreifen, bei dem Probenflüssigkeit von einem Probenaufgabeort zu einem Bestimmungsort transportiert wird, wobei in Transportrichtung stromabwärts vom Probenaufgabeort ein Detektionsort liegt. Wesentlich ist dabei, daß das analytische Testelement zumindest eine Oberfläche aufweist, die aus zumindest einem mit Wasser oxidierbaren Element oder einer mit Wasser oxidierbaren Legierung besteht, welches oder welche durch Einwirken von siedendem Wasser oder Wasserdampf behandelt wurde. Als Elemente und Legierung kommen die oben beschriebenen Stoffe in Frage.

Insbesondere für sogenannte Kapillarspalttestelemente sind hydrophil ausgestattete Oberflächen unerläßlich. Kapillarspalttestelemente sind Testelemente, bei denen die Probenflüssigkeit von einem Probenaufgabeort zu einem davon entfernten Probendetektionsort mit Hilfe kapillarer Kräfte in einem Transportkanal (Kapillarkanal, Kapillarspalt) bewegt werden, um dort eine Nachweisreaktion einzugehen.

Die Bereitschaft einer Kapillare, eine Flüssigkeit aufzusaugen, geht mit der Benetzbarkeit der Kapillarkanaloberfläche mit der Flüssigkeit einher. Für wäßrige Proben bedeutet dies, daß eine Kapillare aus einem Material gefertigt werden sollte, dessen Oberflächenspannung nahe an 72 mN/m heranreicht oder diesen Wert übertrifft.

Ausreichend hydrophile Materialien zum Aufbau einer Kapillare, die schnell wäßrige Proben aufsaugt, sind beispielsweise Glas, Metall oder Keramik. Für den Einsatz in Testträgern weisen diese Materialien jedoch einige Nachteile auf, beispielsweise die Bruchgefahr bei Glas oder Keramik. Üblicherweise werden deshalb zur Fertigung von Testelementen Kunstoffolien oder - formteile eingesetzt. Die verwendeten Kunststoffe übertreffen dabei in der Regel kaum eine Oberflächenspannung von 45 mN/m. Selbst mit den, relativ betrachtet, hydrophilsten Kunststoffen wie beipielsweise Polymethylmethacrylat (PMMA) oder Polyamid (PA) lassen sich - wenn überhaupt - nur sehr langsam saugende Kapillaren aufbauen. Kapillaren aus hydrophoben Kunststoffen wie beispielsweise Polystyrol (PS), Polypropylen (PP) oder Polyethylen (PE) saugen im wesentlichen keine wäßrigen Proben. Hieraus ergibt sich die Notwendigkeit, Kunststoffe für die Verwendung als Konstruktionsmaterial für Testelemente mit kapillaraktiven Kanälen hydrophil auszustatten, das heißt zu hydrophilieren.

Vorzugsweise ist daher in analytischen Testelementen mit Kapillarspalten zumindest eine, besser jedoch zwei, ganz besonders bevorzugt zwei sich gegenüberliegende Flächen der die innere Oberfläche des zum kapillaren Flüssigkeitstransports befähigten Kanals bildenden Flächen, hydrophiliert. Wird mehr als eine Fläche hydrophiliert, so können die Flächen entweder mit der gleichen oder mit unterschiedlichen Methoden hydrophil gemacht werden. Die Hydrophilierung ist vor allem dann notwendig, wenn die Materialien, die den kapillaraktiven Kanal bilden, selbst hydrophob oder nur sehr wenig hydrophil sind, beispielsweise weil sie aus unpolaren Kunststoffen bestehen. Unpolare Kunststoffe, wie zum Beispiel Polystyrol (PS), Polyethylen (PE), Polyethylenterephthalat (PET) oder Polyvinylchlorid (PVC), sind von Vorteil als Trägermaterialien, weil sie die zu untersuchenden Flüssigkeiten nicht absorbieren und damit das Probenvolumen effektiv für die Nachweisreaktion genutzt werden kann. Durch die Hydrophilierung der Oberfläche des Kapillarkanals wird erreicht, daß eine polare, bevorzugt wäßrige Probenflüssigkeit bereitwillig in den kapillaren Kanal eintritt und dort rasch zu der Stelle des Testelements, an der die Detektion stattfindet, transportiert wird.

Ganz besonders bevorzugt wird die Hydrophilierung durch die Verwendung von dünnen Schichten oxidierten Aluminiums erreicht. Diese Schichten werden entweder direkt auf die gewünschten Bauteile des Testelements aufgebracht, beispielsweise durch Vakuumbedampfen der Werkstücke mit metallischem Aluminium und anschließende Oxidation des Metalls, oder in Form von Metallfolien oder metallbeschichteten Kunststoffolien für den Testträgeraufbau verwendet, die ebenfalls zur Erzielung der erwünscheten Hydrophilie oxidiert werden müssen. Metallschichtdicken von 1 bis 500 nm sind dabei ausreichend. Die Metallschicht wird anschließend zu Bildung der oxidierten Form oxidiert, wobei sich erfindungsgemäß vor allem die Oxidation in Gegenwart von Wasserdampf oder durch Kochen in Wasser als besonders geeignete Methoden herausgestellt haben. Die so erzielten Oxidschichten sind je nach Methode zwischen 0,1 und 500 nm, bevorzugt zwischen 10 und 100 nm dick. Größere Schichtdicken sowohl der Metallschicht als auch der Oxidschicht sind zwar prinzipiell praktisch realisierbar, zeigen aber keine weiteren vorteilhaften Wirkungen.

Weitere erfindungsgemäße Verwendungsformen von Oberflächenbeschichtungen sind
- die hydrophile, detergenzfreie Ausrüstung von Polymerfolien, -geweben, -vliesen oder dreidimensionaler Formkörpern zur Verbesserung der Hafteigenschaften für Lack-, Kleber- oder Kunststoffschichten,
- die adsorptive Bindung polarer Moleküle oder Stoffe, insbesondere zur Adsorption von biologisch aktiven Molekülen, wie z. B. Proteinen, Enzymen, Antikörpern, Nukleinsäuren etc. (vgl. hierzu bspw. Chem. Pharm, Bull. **41** (1993) 1055), da die erhöhte Oberflächenspannung mit einer Erhöhung der Polarität der Oberfläche einhergeht,
- die Herstellung von Oberflächenmustern ("Pattern"), beispielsweise Stegen für den Transport von polaren Flüssigkeiten, zur definierten Abgrenzung von polaren und unpolaren Bereichen, wobei diese Muster durch die Struktur des abgeschiedenen Materials selbst oder nachträglich durch selektives Abdecken, mit z. B. Wachs, gewisser Bereiche der abgeschiedenen Materialschicht bei der Behandlung mit siedendem Wasser oder Wasserdampf erzeut werden können.

Die Erfindung wird durch das nachfolgende Beispiel näher erläutert.

### Beispiel 1

### Vergleich der Füllzeiten für eine Prüfkapillare

Eine zylindrische Testkapillare wurde aus zwei sich parallel gegenüberliegenden Folien aufgebaut, die durch einen genau definierten Abstandhalter in Form eines beidseitig klebenden Klebebandes, der die Dimensionen Länge Breite und Höhe der Kapillare bestimmte, in einem definierten Abstand zueinander gehalten wurden. Die sich gegenüberliegenden Oberflächen der beiden Folien waren mit der zu testenden Beschichtung versehen. Die verwendeten Folien waren Polyesterfolien (Melinex®, ICI), die wie folgt unterschiedlich modifiziert wurden:
1.) Folie, die beschichtet wurde mit photoreaktiv ausgerüsteten, hydrophilen Polymeren (BSI)
2.) Folie, die einer Corona-Plasma-Behandlung unterzogen wurde (Antec)
3.) Folie, auf die eine netzmittelhaltige Schicht aufgebracht wurde (A.R.)
4.) Folie, auf die mittels Sol-Gel-Technologie anorganisch-organische Nanokomposite beschichtet wurden (INM)
5.) Folie, auf die Aluminiumoxid aufgedampft wurde, die jedoch nicht anschließend mit siedendem Wasser oder Wasserdampf behandelt wurde (Alu-Ox)
6.) Folie, auf die zunächst eine Schicht Aluminium von 30 nm Dicke aufgedampft wurde, welche anschließend 45 s mit Wasserdampf vollständig oxidiert wurde (Alu-Ox/H₂O)

Die Dimensionen der Kapillare waren 0,1 mm Höhe, 2 mm Breite und 15 mm Länge, wobei die Länge der Transportstrecke der Flüssigkeit entsprach und die Höhe diejenige Dimension war, die die Kapillarität bewirkte. Die Kapillare besaß eine der Aufnahme der Prüfflüssigkeit dienende Öffnung mit einer Querschnittsfläche von 0,1 mm x 2 mm, die der Grundfläche der zylindrischen Kapillare entsprach. Am gegenüberliegenden Ende der Kapillare war eine Entlüftungsöffnung angebracht, die dem Entweichen der verdrängten Luft in der Kapillare beim Einsaugen der Prüfflüssigkeit diente. Die Prüfflüssigkeit war einmal destilliertes Wasser Aqua purificata gemäß DAB und einmal Humanblut (mit EDTA als Antikoagulans, Hämatokrit 44 %). Die Füllzeiten für die Prüfflüssigkeiten wurden bei halber (7,5 mm Transportstrecke) und vollständiger Füllung (15 mm Transportstrecke) gemessen. Die Kapillare wurde beim Füllen senkrecht gehalten, so daß die Prüfflüssigkeit gegen die Schwerkraft die Füllstrecke von 15 mm zurücklegen mußte. Die Vergleichsergebnisse sind in Tabelle 1 festgehalten.

**TABELLE 1**

| **Beschichtung** | **Füllzeit für Blut [s]** | | **Füllzeit für Wasser [s]** |
|---|---|---|---|
| | **nach 7,5 mm** | **nach 15 mm** | **nach 15 mm** |
| BSI | 0,5-0,6 | 2,1-2,7 | 0,6-0,9 |
| Antec | 1,4-2,3 | 4,7-8,4 | 4,0-7,0 |
| A.R. | 0,4-0,5 | 1,8-2,1 | 0,4-0,5 |
| INM | | 1,0 -3,0 | |
| Alu-Ox | - | 1,2 | - |
| Alu-Ox/H₂O | 0,2-0,3 | 0,7 | <0,2 |

Die erfindungsgemäße Beschichtung (Alu-Ox/H₂O) ist die benetzungsaktivste aller geprüften Schichten. Die erfindungsgemäße, nach dem Beschichten des Metalls durch Einwirken von Wasserdampf erzeugte Beschichtung (Alu-Ox/H₂O) weist gegenuber einer direkt mit Aluminiumoxid beschichteten, jedoch nicht unter Einwirken von Wasserdampf oxidierten Oberfläche (Alu-Ox) eine deutlich verbesserte Hydrophilie auf. Das erfindungsgemäße Herstellverfahren ist vergleichsweise einfach, gut zu steuern und führt zu stabilen Beschichtungen mit zeitlich konstanten, hohen Oberflächenspannungen.

## Patentansprüche

1. Verwendung einer Oberflächenbeschichtung zur Erhöhung der Oberflächenspannung von Gegenständen, **dadurch gekennzeichnet, daß** die Oberflächenbeschichtung durch Abscheiden einer Schicht zumindest eines mit Wasser oxidierbaren Elements oder einer mit Wasser oxidierbaren Legierung und anschließendes Einwirken von siedendem Wasser oder Wasserdampf auf die abgeschiedene Schicht erhalten wird.

2. Verwendung einer Oberflächenbeschichtung gemäß Anspruch 1, **dadurch gekennzeichnet, daß** die Oberflächenbeschichtung durch Abscheiden einer Schicht zumindest eines mit Wasser oxidierbaren Elements oder einer mit Wasser oxidierbaren Legierung und anschließendes Einwirken von überhitztem Wasserdampf erhalten wird.

3. Verwendung einer Oberflächenbeschichtung gemäß Anspruch 1 oder 2, **dadurch gekennzeichnet, daß** das Element aus folgender Gruppe von Elementen stammt:
Al, Si, Ti, V, Cr, Mn, Fe, Co, Ni, Zn, Ga, Ge, Zr, Nb, Cd, In, Sn, Sb.

4. Verwendung einer Oberflächenbeschichtung gemäß Anspruch 3, **dadurch gekennzeichnet, daß** das Element aus folgender Gruppe von Elementen stammt:
Al, Si, Ti, Zr.

5. Verwendung einer Oberflächenbeschichtung gemäß Anspruch 4, **dadurch gekennzeichnet, daß** das Element AI ist.

6. Verwendung einer Oberflächenbeschichtung gemäß Anspruch 1 oder 2, **dadurch gekennzeichnet, daß** die Legierung zumindest zwei Komponenten der folgenden Gruppe von Elementen enthält:
Al, Si, Ti, V, Cr, Mn, Fe, Co, Ni, Zn, Ga, Ge, Zr, Nb, Cd, In, Sn, Sb.

7. Verwendung einer Oberflächenbeschichtung gemäß Anspruch 1 oder 2, **dadurch gekennzeichnet, daß** die Legierung zumindest eine Komponente der folgenden ersten Gruppe von Elementen enthält:
AI, Si, Ti, V, Cr, Mn, Fe, Co, Ni, Zn, Ga, Ge, Zr, Nb, Cd, In, Sn, Sb,
die mit zumindest einem Element der folgenden zweiten Gruppe von Elementen:
Mg, Ca, Sr, Ba
legiert ist.

8. Verwendung einer Oberflächenbeschichtung gemäß Anspruch 7, **dadurch gekennzeichnet, daß** die Legierung zumindest eine Komponente der folgenden ersten Gruppe von Elementen enthält:
Al, Si, Ti, Zr,
die mit zumindest einem Element der folgenden zweiten Gruppe von Elementen:
Mg, Ca, Sr, Ba
legiert ist.

9. Verwendung einer Oberflächenbeschichtung gemäß Anspruch 8, **dadurch gekennzeichnet, daß** die Legierung aus Al besteht, welches mit zumindest einem Element der folgenden Gruppe von Elementen:
Mg, Ca, Sr, Ba
legiert ist.

10. Verwendung einer Oberflächenbeschichtung gemäß einem der Ansprüche 1 bis 9, **dadurch gekennzeichnet, daß** die abgeschiedene Schicht zwischen 1 nm und 500 nm dick ist.

11. Verwendung einer Oberflächenbeschichtung gemäß einem der Ansprüche 1 bis 9, **dadurch gekennzeichnet, daß** die oberflächliche Oxidschicht zwischen 0,1 nm und 500 nm dick ist.

12. Verwendung einer Oberflächenbeschichtung gemäß Anspruch 11, **dadurch gekennzeichnet, daß** die oberflächliche Oxidschicht zwischen 10 nm und 100 nm dick ist.

13. Analytisches Testelement, bei dem Probenflüssigkeit von einem Probenaufgabeort zu einem Bestimmungsort transportiert wird, wobei in Transportrichtung stromabwärts vom Probenaufgabeort ein Detektionsort liegt, **dadurch gekennzeichnet, daß** das analytische Testelement zumindest eine Oberfläche aufweist, die aus zumindest einem mit Wasser oxidierbaren Element oder einer mit Wasser oxidierbaren Legierung besteht, welches oder welche durch Einwirken von siedendem Wasser oder Wasserdampf behandelt wurde.

## Claims

1. Use of a surface coating to increase the surface tension of objects, wherein the surface coating is obtained by deposition of a layer of at least one element that can be oxidized with water or an alloy that can be oxidized with water and subsequent action of boiling water or water vapour on the deposited layer.

2. Use of a surface coating as claimed in claim 1, wherein the surface coating is obtained by deposition of a layer of at least one element that can be oxidized with water or an alloy that can be oxidized with water and subsequent action of superheated water vapour.

3. Use of a surface coating as claimed in claim 1 or 2, wherein the element is derived from the following group of elements:
Al, Si, Ti, V, Cr, Mn, Fe, Co, Ni, Zn, Ga, Ge, Zr, Nb, Cd, In, Sn, Sb.

4. Use of a surface coating as claimed in claim 3, wherein the element is derived from the following group of elements:
Al, Si, Ti, Zr.

5. Use of a surface coating as claimed in claim 4, wherein the element is Al.

6. Use of a surface coating as claimed in claim 1 or 2, wherein the alloy contains at least two components from the following group of elements:
Al, Si, Ti, V, Cr, Mn, Fe, Co, Ni, Zn, Ga, Ge, Zr, Nb, Cd, In, Sn, Sb.

7. Use of a surface coating as claimed in claim 1 or 2, wherein the alloy contains at least one component from the following first group of elements:
Al, Si, Ti, V, Cr, Mn, Fe, Co, Ni, Zn, Ga, Ge, Zr, Nb, Cd, In, Sn, Sb,
which is alloyed with at least one element from the following second group of elements:
Mg, Ca, Sr, Ba.

8. Use of a surface coating as claimed in claim 7, wherein the alloy contains at least one component from the following first group of elements:
Al, Si, Ti, Zr,
which is alloyed with at least one element from the following second group of elements:
Mg, Ca, Sr, Ba.

9. Use of a surface coating as claimed in claim 8, wherein the alloy is composed of Al which is alloyed with at least one element from the following group of elements:
Mg, Ca, Sr, Ba.

10. Use of a surface coating as claimed in one of the claims 1 to 9, wherein the deposited layer has a thickness between 1 nm and 500 nm.

11. Use of a surface coating as claimed in one of the claims 1 to 9, wherein the superficial oxide layer has a thickness between 0.1 nm and 500 nm.

12. Use of a surface coating as claimed in claim 11, wherein the superficial oxide layer has a thickness between 10 nm and 100 nm.

13. Analytical test element in which the sample liquid is transported from a sample application site to a determination site, where a detection site lies upstream of the sample application site in the transport direction, wherein the analytical test element has at least one surface which is composed of at least one element that can be oxidized with water or an alloy that can be oxidized with water which has been treated by the action of boiling water or water vapour.

## Revendications

1. Utilisation d'une enduction superficielle pour augmenter la tension superficielle d'objets, **caractérisée en ce qu'**on obtient l'enduction superficielle en précipitant une couche d'au moins d'un élément oxydable avec l'eau ou d'un alliage oxydable avec l'eau et en faisant ensuite agir de la vapeur d'eau ou de l'eau en ébullition sur la couche précipitée.

2. Utilisation d'une enduction superficielle selon la revendication 1, **caractérisée en ce qu'**on obtient l'enduction superficielle en précipitant une couche d'au moins d'un élément oxydable avec l'eau ou d'un alliage oxydable avec l'eau et en faisant ensuite agir de la vapeur d'eau surchauffée.

3. Utilisation d'une enduction superficielle selon la revendication 1 ou 2, **caractérisée en ce que** l'élément est issu du groupe d'éléments ci-après : Al, Si, Ti, V, Cr, Mn, Fe, Co, Ni, Zn, Ga, Ge, Zr, Nb, Cd, In, Sn, Sb.

4. Utilisation d'une enduction superficielle selon la revendication 3, **caractérisée en ce que** l'élément est issu du groupe d'éléments ci-après : Al, Si, Ti, Zr.

5. Utilisation d'une enduction superficielle selon la revendication 4, **caractérisée en ce que** l'élément est Al.

6. Utilisation d'une enduction superficielle selon la revendication 1 ou 2, **caractérisée en ce que** l'alliage contient au moins deux composants choisis parmi le groupe d'éléments ci-après : Al, Si, Ti, V, Cr, Mn, Fe, Co, Ni, Zn, Ga, Ge, Zr, Nb, Cd, In, Sn, Sb.

7. Utilisation d'une enduction superficielle selon la revendication 1 ou 2, **caractérisée en ce que** l'alliage contient au moins un composant choisi parmi le premier groupe d'éléments ci-après : Al, Si, Ti, V, Cr, Mn, Fe, Co, Ni, Zn, Ga, Ge, Zr, Nb, Cd, In, Sn, Sb, qui est allié avec au moins un élément choisi parmi le deuxième groupe d'éléments ci-après : Mg, Ca, Sr, Ba.

8. Utilisation d'une enduction superficielle selon la revendication 7, **caractérisée en ce que** l'alliage contient au moins un composant choisi parmi le premier groupe d'éléments ci-après : Al, Si, Ti, Zr, qui est allié avec au moins un élément choisi parmi le deuxième groupe d'éléments ci-après : Mg, Ca, Sr, Ba.

9. Utilisation d'une enduction superficielle selon la revendication 8, **caractérisée en ce que** l'alliage est constitué de Al qui est allié avec au moins un élément choisi parmi le groupe d'éléments ci-après : Mg, Ca, Sr, Ba.

10. Utilisation d'une enduction superficielle selon l'une quelconque des revendications 1 à 9, **caractérisée en ce que** la couche précipitée possède une épaisseur entre 1 nm et 500 nm.

11. Utilisation d'une enduction superficielle selon l'une quelconque des revendications 1 à 9, **caractérisée en ce que** la couche d'oxyde superficielle possède une épaisseur entre 0,1 nm et 500 nm.

12. Utilisation d'une enduction superficielle selon la revendication 11, **caractérisée en ce que** la couche d'oxyde superficielle possède une épaisseur entre 10 nm et 100 nm.

13. Élément d'essai analytique selon lequel un liquide d'échantillon est transporté d'un endroit de réception d'échantillon à un endroit de détermination, dans lequel est disposé, dans la direction de transport en aval par rapport à l'endroit de réception d'échantillon, un endroit de détection, **caractérisé en ce que** l'élément d'essai analytique présente au moins une surface qui est constituée au moins d'un élément oxydable avec l'eau ou d'un alliage oxydable avec l'eau, ledit élément ou ledit alliage ayant été traité par l'action d'eau en ébullition ou de vapeur d'eau.
